**Europäisches Patentamt**

(19) **European Patent Office**

**Office européen des brevets**

(11) Veröffentlichungsnummer: **0 157 926**

**B1**

(12) # EUROPÄISCHE PATENTSCHRIFT

(45) Veröffentlichungstag der Patentschrift:
06.03.89

(51) Int. Cl.⁴: **H 01 L 21/82,** H 01 L 27/08,
H 01 L 29/60

(21) Anmeldenummer: **84115145.9**

(22) Anmeldetag: **11.12.84**

(54) Verfahren zum Herstellen einer hochintegrierten MOS-Feld-effekttransistorschaltung.

(30) Priorität: **21.03.84 DE 3410378**

(43) Veröffentlichungstag der Anmeldung:
**16.10.85 Patentblatt 85/42**

(45) Bekanntmachung des Hinweises auf die Patenterteilung:
**08.03.89 Patentblatt 89/10**

(84) Benannte Vertragsstaaten:
**AT DE FR GB IT NL**

(56) Entgegenhaltungen:
**EP-A-0 065 168**
**DE-A-3 107 543**
**GB-A-2 026 768**
**GB-A-2 118 364**
**US-A-4 115 796**

**ELECTRONICS INTERNATIONAL, Band 54, Nr. 9, 5.
Mai 1981, Seiten 152-154, New York, US; M. KALET
u.a.: "N-channel process increases speed and
density of MNOS EE-PROMs"**
**ELECTRONICS LETTERS, Band 17, Nr. 18, 3.
September 1981, Seiten 666-667, London, GB; G.
ZIMMER u.a.: "Performance of a scaled Si gate
N-well CMOS technology"**
**ELECTRONICS, Band 52, Nr. 19, 13. September 1979,
Seiten 109-115, New York, US; R.P. CAPECE: "Older
processes revamped as new arrivals extend
performance limits"**

(73) Patentinhaber: **Siemens Aktiengesellschaft Berlin
und München, Wittelsbacherplatz 2, D-8000
München 2 (DE)**

(72) Erfinder: **Scheibe, Adolf, Dr., Ing. Dipl.- Phys.,
Finkenstrasse 9a, D-8012 Ottobrunn (DE)**

EP 0 157 926 B1

## Beschreibung

Die Vorliegende Erfindung betrifft Verfahren zum Herstellen einer hochintegrierten MOS-Feldeffekttransistorschaltung (MOS-Schaltung), bei dem für die Aufnahme der n- bzw. p-Kanal-Transistoren in einem Siliciumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantationen eingebracht werden, wobei die Maskierung für die einzelnen Ionenimplantationen durch Fotolack- und/oder durch Siliciumoxid- bzw. Siliciumnitrid-Strukturen erfolgt, und bei dem die Herstellung der Source/Drain- und Gatebereiche sowie die Erzeugung des Zwischen- und Isolationsoxids und der Leiterbahnebene nach bekannten Verfahrensschritten der MOS-Technologie vorgenomen wird. Ferner betrifft die Erfindung Verfahren zum Herstellen einer hochintegrierten komplementären MOS-Feldeffektransistorschaltung (CMOS-Schaltung).

Moderne CMOS-Prozesse sind Zwei-Wannen-Prozesse, die in ihrem Aufbau entweder einem p-oder n-Wannen-Grundkonzept zuzuordnen sind. D.h., in einem n- bzw. p-dotierten großflächigen Siliciumsubstrat befinden sich physikalische p-bzw. n- Wannen.

Die Herstellung der Wannen und die Einstellung der verschiedenen Transistoreinsatzspannungen (Dünnoxid- und Feldoxidtransistoren in n- und p-Kanal-Bereichen) erfolgt durch mehrfache, aufeinander abgestimmte Ionenimplantationen.

In der Durchführung dieser Prozeßschritte liegen die hauptsächlichen Unterschiede und Nachteile der bekannten CMOS-Prozesse. Der Prozeßablauf eines bekannten n-Wannen-CMOS-Prozesses wird beispielsweise in einem Aufsatz von T. Ohzone et al in der US-Zeitschrift IEEE Trans. Electr. Dev., ED-27 Nr. 9 (1980) auf den Seiten 1789 bis 1795 beschrieben.

Aus der DE-A-3 107 543 ist eine integrierte MIS-Halbleiterschaltungsvorrichtung und ein Herstellverfahren mit einem Doppel-Polysiliciumprozeß für Transistoren unterschiedlicher Spannungsfestigkeit bekannt. Zur Herstellung von Transistoren unterschiedlicher Spannungsfestigkeit, aber gleichen Schwellenspannungen wird zunächst eine Schicht aufoxidiert, von der selektive Bereiche einer Ionenimplantation unterzogen werden. Anschließend wird die gesamte Oberfläche geätzt und eine erneute Oxidation vorgenommen, der sich ein Implantationsschritt für die selektiven und nichtselektiven Bereiche anschließt. Der Hochspannungstransistor wird in den nichtseleketiven Bereichen gebildet, in denen die Oxidschicht aufgrund der Doppeloxidation dicker ist. Die Einstellung der Schwellenspannungen der Transistoren erfolgt durch eine Dotierung der Substratoberfläche.

Die bekannten MOS- und CMOS-Prozesse sind im allgemeinen auf eine bestinmte Betriebsspannung, beispielsweise 5 V optimiert und erlauben aufgrund mangelnder Spannungsfestigkeit der auf Geschwindigkeit optimierten n-Kanal-MOS-Transistoren, die durch kleine effektive Kanallängen und dünne Gateoxide gekennzeichnet sind, keinen Einsatz bei höheren Spannungen. Für eine Vielzahl von Anwendungen besteht jedoch der Wunsch, auf der auf niedrige Betriebsspannung ausgelegten MOS- oder CMOS-Halbleiterschaltung auch Teilschaltungen für höhere Spannungen zu integrieren. Beispiele dazu sind Digital-Analog-Wandler oder nichtflüchtige Speicher.

Der Erfindung lag die Aufgabe zugrunde, ein Verfahren zum Herstellen einer hochintegrierten MOS-Feldeffektransistoranordnung anzugeben, mit dem einerseits sehr schnelle und andererseits sehr spannungsfeste Transistoren mit wenigen Verfahrensschritten hergestellt werden können.

Diese Aufgabe wird bei einem Verfahren der eingangs genannten Art durch die im kennzeichnenden Teil des Anspruchs 1 aufgeführten Merkmale gelöst. Die Erfindung hat den Vorteil, daß Teilschaltungen mit spannungsfestigkeitsoptimierten n- oder p-Kanal-Transistoren mit geschwindigkeitsoptimierten Teilschaltungen auf einer einzigen Halbleiterschaltung sowohl für MOS- als auch für CMOS-Schaltungen herstellbar sind.

Da eine Ausrichtung von Strukturabmessungen und/oder Verfahrensschritte der gesamten Halbleiterschaltung auf die gewünschte maximale Betriebsspannung vermieden wird, treten die Nachteile für die Leistungsfähigkeit der geschwindigkeitsbestimmenden n-Kanal-Transistoren nicht auf. Es ist also keine Vergrößerung der Kanallänge, keine höhere Unterdiffusion oder höhere Gateoxiddicke im Vergleich zu Standardschaltungen erforderlich.

Weiterbildungen der Erfindung ergeben sich aus den Unteransprüchen.

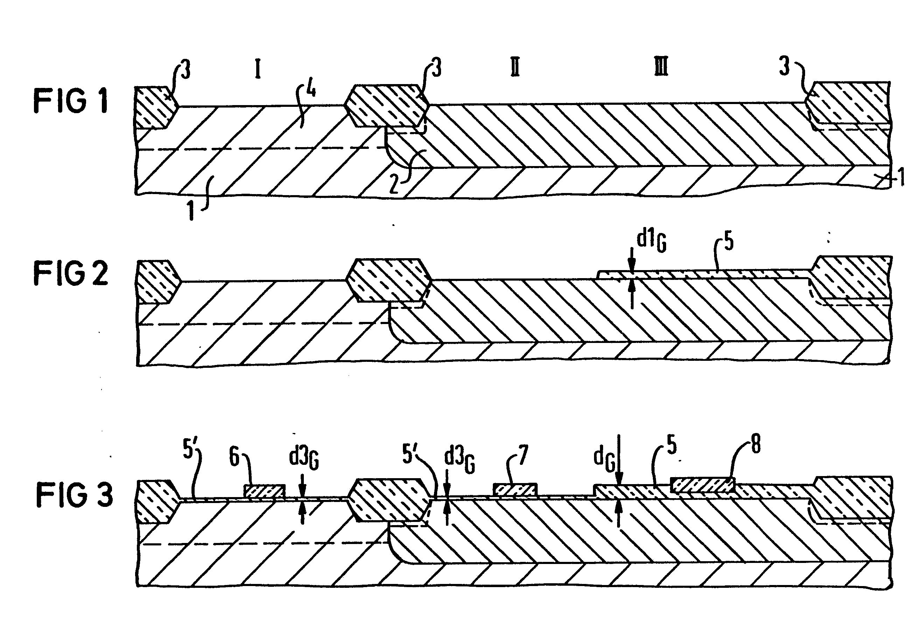

Im folgenden wird die Erfindung am Beispiel eines n-Kanal-Transistors in CMOS-Technik weiter erläutert. Die einzelnen Verfahrensschritte sind anhand von Querschnittsskizzen (Fig. 1 bis Fig. 8) erläutert.

Fig. 1: Bis zu dem in Fig. 2 gezeigten Verfahrensschritt zur Erzeugung einer Gate-Oxidschicht 5,5' sind die bekannten Verfahren der CMOS-Prozeßtechnologie anwendbar. Der besseren Übersicht wegen wird deshalb auf die Einzeichnungen der durch die bekannten Prozeßschritte erhaltenen Strukturen mit Ausnahme der im n-dotierten Siliciumsubstrat 1 für die n-Kanal-Transistoren erforderlichen p-Wanne 2, der für die p-Kanal-Transistoren erforderlichen n-Wanne 4 und des Feldoxids 3 verzichtet. Dieses weist - um eine beispielhafte Größenordnung anzugeben - eine Dicke von 0,9 µm auf.

Der Bereich, in welchem der p-Kanal-Transistor erzeugt wird, ist als erster Bereich I bezeichnet. In den mit "II" und "III" bezeichneten zweiten bzw. dritten Bereichen entsteht ein geschwindigkeitsoptimierter bzw. spannungsoptimierter n-Kanal-Transistor.

Fig. 2: Anschließend an diese Verfahrensschritte eines Standardprozesses erfolgt die Bildung eines Gateoxids 5. Die Oxidationsbedingungen werden so gewählt, daß ganzflächig eine erste Schichtdicke $d1_G$ entsteht. Diese ist so bemessen, daß sie zusammen mit der im nächsten Verfahrensschritt (Fig. 3) durchgeführten Oxidation im Bereich III ihre endgültige Stärke erhält. Bei einer Enddicke $d_G$ des Oxids im Bereich III von beispielsweise 80 nm, wird in dem beschriebenen ersten Oxidationsschritt eine Schicht der ersten Schichtdicke $d1_G = 65$ nm erzeugt, die imzweiten Oxidationsschritt um weitere 15 nm aufoxidiert wird.

Nach dem ersten Oxidationsschritt wird im Bereich I und II die erste Oxidschicht 5 durch Ätzung wieder entfernt, so daß sie lediglich im Bereich III erhalten bleibt. Die Fig. 2 zeigt diesen Zustand der Substratoberfläche.

Fig. 3: Anschließend wird in einem zweiten Oxidationsschritt wieder eine ganzflächige Oxidation durchgeführt. Dabei wächst das Gateoxid 5 im dritten Bereich III auf seine Enddicke $d2_G$ an und gleichzeitig entsteht in den beiden Bereichen I, II Schicht mit der zweiten Schichtdicke $d3_G$.

Auf diese Oberfläche erfolgt nun eine Polysilicium Abscheidung von beispielsweise 0,5 µm. Diese wird mit einem Datierstoff belegt. Zur Strukturierung von Elektroden 6, 7, 8 aus dem Polysilicium wird eine Maske aufgebracht, an die sich eine Ätzung und eine Lackentfernung anschließt. Dies ist der Ausgangszustand für die in den folgenden Figuren beschriebenen Verfahrensschritte. Alternativ dazu kann der Maskenschritt auch eine Ätzung des freiliegenden Gateoxids in den Bereichen II und III enthalten. In diesem Fall ist aber vor den weiteren Verfahrensschritten ein thermisches Schirmoxid von beispielsweise 20 bis 30 nm aufzubringen und die Implantationsenergie der folgenden Implantationsschritte dieser Dicke anzupassen.

Die bisher beschriebenen Verfahrensschritte erhöhen die Spannungsfestigkeit des erzeugten Transistorschaltkreises. Das Herstellungsverfahren kann sowohl durch die bekannten Verfahrensschritte, beispielsweise auch durch eine Arsen-Implantation der n+- Source-Drain-Bereiche II und III abgeschlossen werden, als auch durch die im folgenden beschriebenen Verfahrensschritte, durch die die Spannungsfestigkeit im dritten Bereich III weiter erhöht wird. Außerdem wird der Schaltkreis durch die im folgenden beschriebenen Verfahrensschritte im zweiten Bereich II geschwindigkeitsoptimiert. Es ist darauf hinzuweisen, daß das folgende Verfahren alternativ zu dem oben beschriebenen Verfahren als auch im Anschluß daran anwendbar ist.

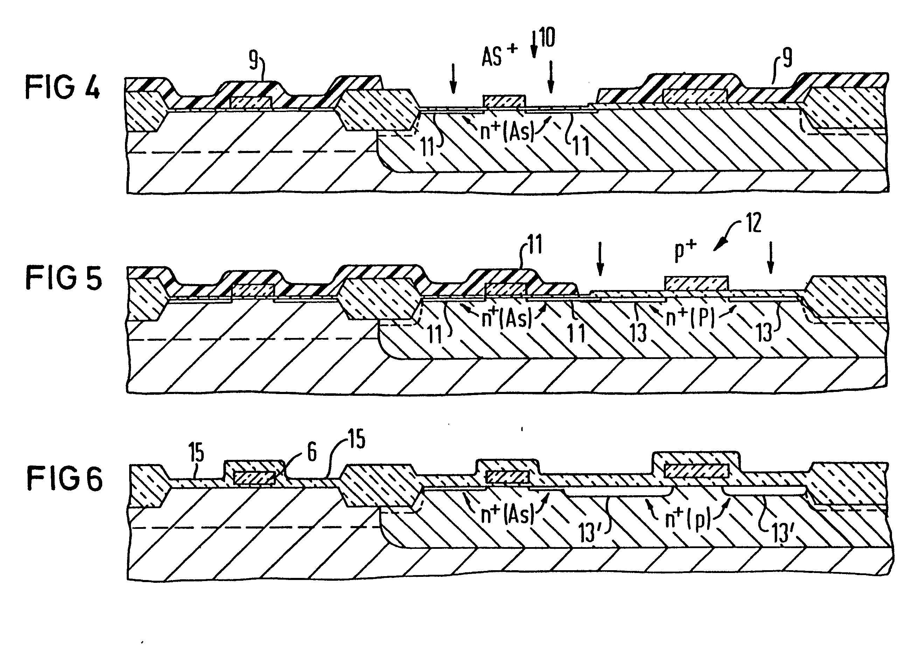

Fig. 4: Es wird eine Lackmaske 9 aufgebracht, welche zur folgenden Implantation 10 mit Arsen (erste Dotieratome) im zweiten Bereich II ein Fenster bildet. Die Implantationsenergie ist der dritten Schichtdicke $d3_G$ anzupassen. Für das bereits wiederholt angeführte Beispiel ist dazu eine Dosis Von $5 . 10^{15}$ cm$^{-2}$ und eine Energie von 80 kev einzustellen. Es entstehen Source-Drain-Bereiche 11 für den geschwindigkeitsoptimierten n-Kanaltransistor, der im Vergleich zu einer Phosphor-Implantation eine geringere Unterdiffusion aufweist.

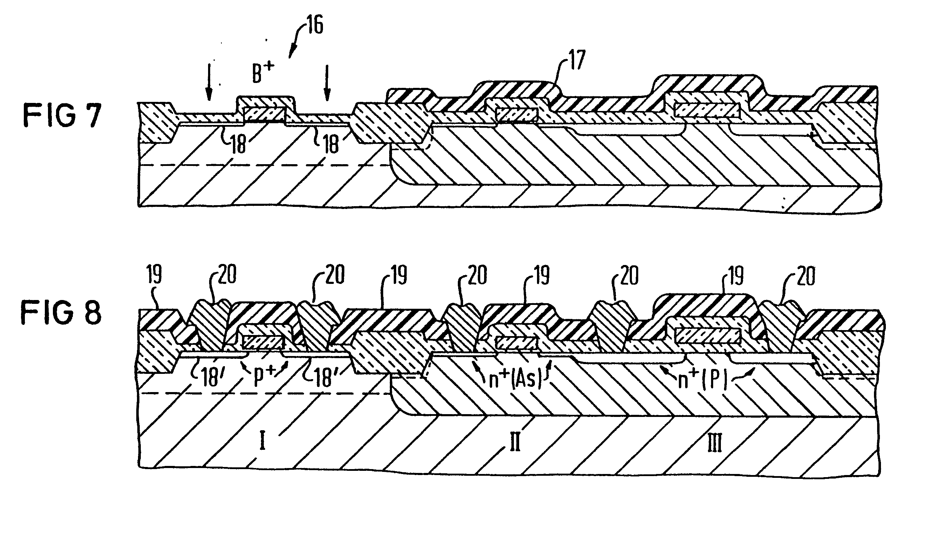

Fig. 5: Die Maske 9 wird entfernt, eine weitere Maske 11 wird aufgebracht und im dritten Bereich III entfernt, um ein Fenster für eine Phosphor + Implantation 12 mit Phosphor (zweite Dotieratome) zu öffnen.

Ferner sind auch andere Verfahren anwendbar, wenn es die technologische Zielsetzung, beispielsweise eine kleinere Unterdiffusion, erfordert.

Die Energie bei der Phosphor - Implantation ist der Enddicke $d_G$ des Gateoxids 5 anzupassen. Im Ausführungsbeispiel der Enddicke $d_G = 80$ nm ist die Energie $\geq 100$ kev und die Dotierung kleiner oder gleich $5 . 10^{15}$ cm$^{-2}$.

In einem kurzen Ätzschritt wird die verunreinigte Gateoxid- bzw. Maskenoberfläche entfernt.

Fig. 6: In einem Temperaturschritt (sog Drive in) werden die implantierten Dotierstoffatome eingetrieben. Auf diese Weise entstehen die Source/Drain- Bereiche 11 im Bereich II mit kleiner Unterdiffusion unter dem geschwindigkeitsoptimierten n-Kanal-Transistor bzw. 13 im dritten Bereich III mit größerer Unterdiffusion unter dem spannungsoptimierten n-Kanal-Transistor.

Alternativ dazu kann dieser gemeinsame Temperaturabschnitt jedoch aufgespalten und dem jeweiligen Dotierprofilzielen für die Source/Drain-Bereiche 11 und 13 angepaßt werden, indem beispielsweise unmittelbar nach jedem Implantationsschritt ein Temperaturschritt durchgeführt wird.

In der folgenden ganzflächigen Oxidation wird auf dem n+ -dotierten Gate 6 des p- Kanaltransistors im ersten Bereich I eine durch Aufoxidieren auf die Oxidschicht 5' entstehende, maskierende Schicht 15 gegen die folgende p+ Implantation gebildet. Die Oxidationsbedingungen werden so gewählt, daß die im entstehenden p+-Diffusionsbereich erfolgende Fertigung der ursprünglichen Oxidationsschicht 5' noch eine ausreichende Durchimplantation gewährleisten.

Fig. 7: Auf das Substrat wird eine Lackmaske 17 in der Weise aufgebracht, daß ein Fenster im p+-Diffusionsbereich geöffnet bleibt. Es erfolgt eine Bor+-Implantation, deren Energie der Dicke der in vorhergehenden Oxidationsschritt gebildeten Oxidschicht 5 angepaßt ist, wobei die Source-Drain-Bereiche 18 des p-Kanal-Transistors entstehen.

Fig. 8: Alle weiteren Verfahrensschritte, wie Aufbringen des Isolationsoxids 19, Einbringen der Kontaktlöcher, Herstellen der metallischen Leiterbahnebene 20, beispielsweise aus Aluminium oder Silicium, und Passivierung der Schaltung erfolgen in bekannter Weise.

Die anhand der Fig. 4 bis 7 beschriebenen Verfahrensschritte bewirken p-n-Übergänge mit relativ großem Krümmungsradius und/oder weicherem Dotierprofil im Bereich der Unterdiffusion des n-Kanal-Transistors, was die Spannungsbelastbarkeit heraufsetzt. Wie bereits erwähnt, sind die beiden beschriebenen Verfahren sowohl alternativ, als auch in Verbindung miteinander anwendbar.

**Patentansprüche**

1. Verfahren zum Herstellen einer hochintegrierten MOS-Feldeffekt-Transistorschaltung (MOS-Schaltung), bei dem für die Aufnahme der n- bzw. p-Kanal-Transistoren in einem Silicium-Substrat p- bzw. n-dotierte Wannen erzeugt werden, in welche zur Einstellung der verschiedenen Transistor-Einsatzspannungen die entsprechenden Dotierstoffatome durch mehrfache Ionenimplantationen eingebracht werden, wobei die Maskierung für die einzelnen Ionenimplantationen durch Fotolack- und/oder durch Siliciumoxid bzw. Siliciumnitrid-Strukturen erfolgt, und bei dem die Herstellung der Source/Drain- und Gatebereiche sowie die Erzeugung des Zwischen- und Isolationsoxids und der Leiterbahnebene nach bekannten Verfahrensschritten der MOS-Technologie vorgenommen wird,
gekennzeichnet durch folgende Verfahrensschritte:

A) Aufbringen einer Maske (9) auf einer Oxidschicht mit einem Fenster in einem Bereich (II) einer p-dotierten Wanne;
B) Durchführen einer Implantation mit ersten n-Typ-Dotierstoffatomen zur Erzeugung der n+-Source-Drain-Bereiche (11) eines ersten n-Kanal-Transistors, wobei die Dosis und die Implantationsenergie der Dicke der Oxidschicht im Fensterbereich angepaßt wird;
C) Aufbringen einer Maske (11) auf der Oxidschicht mit einem Fenster in einem anderen Bereich (III) der gleichen p-dotierten Wanne;
D) Durchführen einer Implantation mit zweiten n-Typ-Dotierstoffatomen zur Erzeugung der n+-Source-Drain-Bereiche (13) eines zweiten n-Kanal-Transistors, wobei die Dosis und Implantationsenergie einer Enddicke ($d_G$) der Oxidschicht im Fenster des anderen Bereichs angepaßt wird;
E) Entfernen der verunreinigten Oxidoberfläche;
F) Eintreiben der implantierten Dotierstoffatome in die beiden Bereiche (II,III).

2. Verfahren nach Anspruch 1,
dadurch gekennzeichnet, daß im Verfahrensschritt F) das Eintreiben in die beiden Bereiche (II, III) unter Vertauschung der in den Verfahrensschritten B) bzw. D) verwendeten ersten bzw. zweiten n-Typ-Dotierstoffatome durchgeführt wird.

3. Verfahren nach einem der Ansprüche 1 oder 2,
dadurch gekennzeichnet, daß als erste n-Typ-Dotierstoffatome und als zweite n-Typ-Dotierstoffatome gleichartige Dotierstoffatome verwendet werden.

4. Verfahren nach einem der Ansprüche 1 bis 3, gekennzeichnet durch folgende Verfahrensschritte vor den Verfahrensschritten A) bis F):

a) Aufbringen einer ganzflächige Oxidschicht mit einer ersten Schichtdicke ($d1_G$);
b) Entfernen des Oxids im einen, dem ersten n-Kanal-Transistor zugeordneten Bereich (11);
c) Aufbringen einer weiteren ganzflächigen Oxidschicht in der Weise, daß im anderen, dem zweiten n-Kanal-Transistor zugeordneten Bereich (III) die Oxidschicht die Enddicke ($d_G$) erreicht, die stärker ist als die erste Schichtdicke ($d1_G$).

5. Verfahren nach Anspruch 4 zum Herstellen einer hochintegrierten komplementären MOS-Feldeffekttransistorschaltung,
dadurch gekennzeichnet, daß im Verfahrensschritt b) die Oxidschicht in einem weiteren, einem p-Kanal-Transistor zugeordneten Bereich (I) ebenfalls entfernt wird.

6. Verfahren nach einem der Ansprüche 4 oder 5,
dadurch gekennzeichnet, daß in dem Verfahrensschritt c) die Bedingungen zum Aufbringen der weiteren Oxidschicht so gewählt werden, daß die Oxidschicht im weiteren Bereich (I) auf eine zweite Schichtdicke ($d3_G$) anwächst, die kleiner ist als die Enddicke ($d_G$).

7. Verfahren nach einem der vorhergehenden Ansprüche,
dadurch gekennzeichnet, daß die erste Schichtdicke ($d1_G$) auf einen Wert von etwa 65 nm und die Enddicke ($d_G$) auf einen Wert von etwa 80 nm anwachsen.

8. Verfahren nach Anspruch 6,
dadurch gekennzeichnet, daß die zweite Schichtdicke ($d3_G$) einen Wert von etwa 40 nm annimmt.

9. Verfahren nach einem der vorhergehenden Ansprüche,
dadurch gekennzeichnet, daß der Dotierungstyp der jeweiligen Dotierstoffatome, Bereiche, Wannen und Transistoren gegen den entsprechenden komplementären Dotierungstyp vertauscht wird.

10. Verfahren nach einem der Ansprüche 1 bis 8,

dadurch gekennzeichnet, daß als erste n-Typ-Dotierstoffatome Arsenatome und als zweite n-Typ-Dotierstoffatome Phosphoratome verwendet werden.

## Claims

1. Method for producing a highly integrated circuit of MOS field-effect transistors (MOS circuit), in which p- or n-doped troughs are produced for accommodating the n- or p-channel transistors in a silicon substrate, into which troughs the appropriate dopant atoms are introduced by multiple ion implantations for setting the various transistor operating voltages, the masking for the individual ion implantations being effected by photoresist and/or by means of silicon oxide or silicon nitride structures, and in which the source/drain and gate regions and the intermediate and insulation oxide and the conductor track plane are produced in accordance with known steps of the MOS technology method, characterized by the following method steps:

A) Applying a mask (9) to an oxide layer having a window in a region (II) of a p-doped trough;

B) Carrying out an implantation with first n-type dopant atoms for producing the n -type source/drain regions (11) of a first n-channel transistor, the dose and the implantation energy being adapted to the thickness of the oxide layer in the window area;

C) Applying a mask (11) to the oxide layer with a window in a different region (III) of the same p-doped trough;

D) Carrying out an implantation with second n-type dopant atoms for producing the n+-type source/drain regions (13) of a second n-channel transistor, the dose and implantation energy being adapted to a final thickness $(d_G)$ of the oxide layer in the window of the other region;

E) Removing the contaminated oxide surface;

F) Driving the implanted dopant atoms into the two regions (II, III).

2. Method according to Claim 1, characterized in that, in method step F), the driving into the two regions (II, III) is performed interchanging the first and second n-type dopant atoms used in methods steps B) and D), respectively.

3. Method according to one of Claims 1 or 2, characterized in that similar dopant atoms are used as first n-type dopant atoms and as second n-type dopant atoms.

4. Method according to one of Claims 1 to 3, characterized by the following method steps, preceding method steps A) to F):

a) Applying an oxide layer having a first layer thickness $(d1_G)$ over the entire area;

b) Removing the oxide in a region (II) assigned to the first n-channel transistor;

c) Applying a further oxide layer over the entire area in such a manner that the oxide layer attains in the other region (III) assigned to the second n-channel transistor the final thickness $(d_G)$ which is thicker than the first layer thickness $(d1_G)$.

5. Method according to Claim 4 for producing a highly-integrated circuit of complementary MOS field-effect transistors, characterized in that, in method step b) the oxide layer is also removed in a further region (I) assigned to a p-channel transistor.

6. Method according to one of Claims 4 or 5, characterized in that, in method step c) the conditions for applying the further oxide layer are selected in such a manner that the oxide layer in the further region (I) grows to a second layer thickness $(d3_G)$ which is less than the final thickness $(d_G)$

7. Method according to one of the preceding claims, characterized in that the first layer thickness $(d1_G)$ grows to a value of about 65 nm and the final thickness $(d_G)$ grows to a value of about 80 nm.

8. Method according to Claim 6, characterized in that the second layer thickness $(d3_G)$ assumes a value of about 40 nm.

9. Method according to one of the preceding claims, characterized in that the doping type of the respective dopant atoms, regions, troughs and transistors is interchanged against the corresponding complementary doping type.

10. Method according to one of Claims 1 to 6, characterized in that arsenic atoms are used as first n-type dopant atoms and phosphorous atoms are used as second n-type dopant atoms.

## Revendications

1. Procédé pour fabriquer un circuit à transistors à effet de champ MOS (circuit MOS) à haute densité d'intégration, selon lequel, pour loger des transistors a canal n ou à canal p, on aménage, dans un substrat en silicium, des cuvettes dopées du type p ou du type n, dans lesquelles, pour le réglage des différentes tensions de service du transistor, on introduit les atomes correspondants de substances dopantes au moyen d'implantations ioniques multiples, le masquage s'effectuant pour les différentes implantations ioniques au moyen de structures de laque photosensible et/ou au moyen de structures d'oxyde de silicium ou de nitrure de silicium, et selon lequel on réalise la fabrication des régions de source/drain et de grille ainsi que la fabrication de l'oxyde intermédiaire et de l'oxyde isolant et des voies conductrices conformément à des étapes opératoires connues de la technologie MOS, caractérisé par les étapes opératoires suivantes:

A) dépôt d'un masque (9) sur une couche d'oxyde, avec une fenêtre présente dans une zone (II) d'une cuvette dopée de type p;

B) exécution d'une implantation avec des premiers atomes de substance dopante de type n pour la réalisation des régions de source et de drain (11) de type n+ d'un premier transistor à canal n, la dose et l'énergie d'implantation étant adaptées à l'épaisseur de la couche d'oxyde dans la zone de la fenêtre;

C) dépôt d'un masque (11) sur la couche d'oxyde, avec une fenêtre dans une autre zone (III) de la même cuvette dopée de type p;

D) exécution d'une implantation avec des seconds atomes de substance dopante de type n pour l'obtention des régions de source et de drain (13) de type n+ d'un second transistor à canal n, la dose et l'énergie d'implantation étant adaptées à une épaisseur finale ($d_G$) de la couche d'oxyde dans la fenêtre de l'autre zone;

E) élimination de la surface d'oxyde impure;

F) pénétration des atomes de substance dopante implantés dans les deux zones (II, III).

2. Procédé suivant la revendication 1, caractérisé par le fait que lors de l'étape opératoire F), la pénétration dans les deux zones (II, III) est exécutée moyennant une permutation des premiers et seconds atomes de substance dopante de type n utilisés lors des étapes opératoires B) et D).

3. Procédé suivant l'une des revendications 1 ou 2, caractérisé par le fait qu'on utilise des atomes de substance dopante de même sorte en tant que premiers atomes de substance dopante de type n et en tant que seconds atomes de substance dopante de type n.

4. Procédé suivant l'une des revendications 1 à 3, caractérisé par les étapes opératoires suivantes mises en oeuvre avant les étapes opératoires A) à F):

a) dépôt, sur toute la surface, d'une couche d'oxyde possédant une première épaisseur ($d1_G$);

b) élimination de l'oxyde dans une zone (II) associée au premier transistor à canal n;

c) dépôt d'une autre couche d'oxyde, qui s'étend sur toute la surface, de manière que dans l'autre zone (III) associée au second transistor à canal n, la couche d'oxyde atteint l'épaisseur finale ($d_G$), qui est supérieure à la première épaisseur de couche ($d1_G$).

5. Procédé suivant la revendication 4 pour fabriquer un circuit à transistors à effet de champ MOS complémentaire à haute densité d'intégration, caractérisé par le fait que lors de l'étape opératoire b), on élimine également la couche d'oxyde dans une autre zone (I) associée à un transistor à canal p.

6. Procédé suivant l'une des revendications 4 ou 5, caractérisé par le fait que lors de l'étape opératoire c), les conditions pour le dépôt de l'autre couche d'oxyde sont choisies de manière que la couche d'oxyde dans l'autre zone (I) se développe sur une seconde épaisseur ($d3_G$), qui est inférieure à l'épaisseur finale ($d_G$).

7. Procédé suivant l'une des revendications précédentes, caractérisé par le fait que la première épaisseur de couche ($d1_G$) augmente jusqu'à une valeur d'environ 65 nm et que l'épaisseur finale ($d_G$) augmente jusqu'à une valeur d'environ 80 nm.

8. Procédé suivant la revendication 6, caractérisé par le fait que la seconde épaisseur de couche ($d3_G$) possède une valeur d'environ 40 nm.

9. Procédé suivant l'une des revendications précédentes, caractérisé par le fait que le type de dopage des atomes respectifs de substances dopantes, des zones, des cuvettes et des transistors est permuté par rapport au type de dopage correspondant complémentaire.

10. Procédé suivant l'une des revendications 1 à 8, caractérisé par le fait qu'on utilise des atomes d'arsenic comme premiers atomes de substance dopante de type n et des atomes de phosphore comme seconds atomes de substance dopante de type n.

FIG 1

FIG 2

FIG 3

EP 0 157 926 B1

**FIG 4**

AS $^+$ $\downarrow$ 10

9

9

11

n $^+$ (As)

11

**FIG 5**

11

p $^+$ 12

11

11

n $^+$ (As)

11

13

n $^+$ (P)

13

**FIG 6**

15

6

15

n $^+$ (As)

13'

n $^+$ (p)

13'

FIG 7

FIG 8